# EUROPÄISCHE PATENTSCHRIFT

(11) **EP 2 389 240 B1**
(45) Veröffentlichungstag und Bekanntmachung des Hinweises auf die Patenterteilung: **03.10.2018**
(21) Anmeldenummer: 09748038.8
(22) Anmeldetag: 28.10.2009
(51) Int. Cl.: B01J 3/03

(54) **VAKUUMKAMMER FÜR BESCHICHTUNGSANLAGEN UND VERFAHREN ZUM HERSTELLEN EINER VAKUUMKAMMER FÜR BESCHICHTUNGSANLAGEN**
VACUUM CHAMBER FOR COATING INSTALLATIONS AND METHOD FOR PRODUCING A VACUUM CHAMBER FOR COATING INSTALLATIONS
CHAMBRE À VIDE POUR INSTALLATIONS DE REVÊTEMENT ET PROCÉDÉ DE FABRICATION D'UNE CHAMBRE À VIDE POUR INSTALLATIONS DE REVÊTEMENT

(30) Priorität: 21.01.2009 US 146016 P; 08.02.2009 DE 102009007897
(43) Veröffentlichungstag der Anmeldung: 30.11.2011
(73) Patentinhaber: Oerlikon Surface Solutions AG, Pfäffikon, 8808 Pfäffikon (CH)
(72) Erfinder: ESSELBACH, Markus, A-6800 Feldkirch (AT)
(74) Vertreter: Kempkens, Anke
(86) Internationale Anmeldenummer: PCT/EP2009/007703
(87) Internationale Veröffentlichungsnummer: WO 2010/083856

(56) Entgegenhaltungen:
- EP-A1- 1 585 612
- DE-A1- 19 857 979
- JP-A- S6 268 538
- US-A- 4 951 601
- US-A- 5 783 492
- US-A1- 2004 187 781
- US-A1- 2007 051 304

## Beschreibung

Die vorliegende Erfindung betrifft eine Vakuumkammer für Beschichtungsanlagen gemäß dem Oberbegriff des Anspruchs 1 sowie ein Verfahren zum Herstellen einer Vakuumkammer für Beschichtungsanlagen gemäß dem Oberbegriff des Anspruchs 10. Die als PVD oder CVD bekannten Beschichtungsverfahren bezeichnen beispielsweise Beschichtungsverfahren unter Vakuumbedingungen. Bei der PVD (physical vapor deposition) beruht der Beschichtungsprozess im Wesentlichen auf physikalischer Abscheidung von Material auf einem zu beschichtenden Werkstück. Bei der CVD (chemical vapor deposition) beruht der Beschichtungsprozess im Wesentlichen auf chemischen Reaktionen. Beiden Verfahren ist gemein, dass sie oftmals unter Hochvakuumbedingungen (HV, 10⁻³mbar bis 10⁻⁷mbar) oder unter Ultrahochvakuumbedingungen (UHV, 10⁻⁷mbar bis 10⁻¹²mbar) durchgeführt werden. Im Rahmen der vorliegenden Erfindung soll unter Vakuum der Zustand eines Fluids in einem Volumen bezeichnet werden, wobei der Druck geringer als 10⁻¹ mbar ist.
Zur Erzeugung eines Vakuums wird in der Regel aus einer dicht verschlossenen Kammer ein Fluid abgepumpt. Typischerweise ist eine derartige Kammer aus einem einstückigen Kammerkörper, der in der Regel aus Edelstahl hergestellt ist, aufgebaut. Durch eine derartige einstückige Ausgestaltung der Vakuumkammer werden möglicherweise auftretende Leckagen vermieden und außerdem kann ein gutes Vakuum erzeugt werden.

Die Verwendung eines einstückigen Kammerkörpers ist jedoch dann von Nachteil, wenn an der Anlage Änderungen vorgenommen werden sollen, da diese dann an dem einstückigen Kammerkörper nur mit großem Aufwand (Trennen, Schweissen etc.) durchführbar sind.

Um dieses Problem zu lösen, wird in DE 94 040 22 eine Vakuumkammer vorgeschlagen, welche nicht einstückig sondern modular hergestellt ist. Dabei ist die Vakuumkammer in mehrere Funktionsebenen (Target-, Quellen-und Pumpebene), welche durch flanschverbundene Bereiche aufgebaut sind, unterteilt. Durch Vorsehen einer lösbaren Verbindung der flanschverbundenen Bereiche werden Umbaumassnahmen an der Vakuumkammer vereinfacht und somit werden auch die Kosten für einen Umbau der Vakuumkammer reduziert. Außerdem kann für spätere Erweiterungen der obere und untere Abschluss mit flanschverbundenen Deckeln erfolgen.

Obwohl das Vorsehen der flanschverbundenen Bereiche gemäß der in DE 94 940 22 beschriebenen Vakuumkammer eine erhöhte Flexibilität hinsichtlich Änderungen oder Modifikationen der Vakuumkammer gegenüber den einstückig hergestellten Vakuumkammern bietet, ist dagegen die Statik der Vakuumkammer hierbei ein Problem, denn es muss sichergestellt werden, dass die durch die flanschverbundenen Teile aufgebaute Kammer die erforderliche Stabilität aufweist.

In einer früheren Anmeldung desselben Anmelders wird demgegenüber eine Vakuumkammer angegeben, welche auf einer Rahmenbasis aufgebaut ist, wobei die Grundfläche des Rahmens und die Stege einstückig gefertigt sind. Hierzu werden die Stege dadurch gebildet, dass herausragende Arme der Platte vertikal nach oben gebogen werden und so an diesen Stellen keine Schweissarbeiten notwendig sind. Es werden daher lediglich die Rahmenbestandteile der Türe sowie der Deckplatte verschweisst. Der Rahmen bildet für die Kammer ein Gerüst in welches zur Vervollständigung Einsatzplatten einsetzbar sind. Auf den Einsatzplatten können An- und Einbaugeräte, wie zum Beispiel Pumpen, Target oder Quelle vormontiert sein. Die Einsatzplatten werden mit dem Rahmen mechanisch und vakuumdicht verbunden. Zur Herstellung mehrerer unterschiedlicher Vakuumkammern können die Rahmen dabei als Modul in großer Anzahl standardisiert und somit bei niedrigen Kosten hergestellt werden. Im Falle spezifischer Kundenanforderungen muss der Rahmen überhaupt nicht mehr bearbeitet werden, da Kundenspezifikationen vollständig über die Anpassung der Einsatzplatten berücksichtigt werden können. Die daran vorgesehenen Funktionselemente, wie zum Beispiel Target, Quelle oder Vakuumpumpe, aber auch beispielsweise Sichtfenster können relativ zueinander von Kammer zu Kammer in unterschiedlicher Weise angeordnet werden.

Die Patentschriften US 2004/187781 A1 und JP S62 68538 A offenbaren Vakuumkammern mit Boden- und Deckelplatte. Bei dem oben beschriebenen aus dem Stand der Technik bekannten Aufbau einer Vakuumkammer besteht jedoch ein Nachteil darin, dass die zur Erstellung des Rahmens benötigte Platte dünn genug sein muss, um das Biegen der Stege oder des Mantelteils des Rahmens zu ermöglichen, was auch wiederum zu verminderter Stabilität des Rahmens führt.

Der vorliegenden Erfindung liegt daher die Aufgabe zugrunde, eine flexibel an Änderungen und Modifikationen anpassbare Vakuumkammer vorzusehen, welche dennoch eine erhöhte Stabilität aufweist.
Erfindungsgemäss wird die Aufgabe durch eine Vakuumkammer für Beschichtungsanlagen mit den Merkmalen gemäß Anspruch 1 sowie durch ein Verfahren zum Herstellen einer Vakuumkammer für Beschichtungsanlagen mit den Merkmalen gemäß Anspruch 10 gelöst. Vorteilhafte Weiterbildungen sind in den jeweiligen Unteransprüchen definiert.
Erfindungsgemäss wird eine Vakuumkammer für Beschichtungsanlagen vorgesehen, wobei die Vakuumkammer eine Bodenplatte und eine Deckelplatte aufweist, welche durch im Wesentlichen senkrecht zu der Bodenplatte und der Deckelplatte verlaufenden Streben miteinander verbunden sind, wobei eine Vielzahl von Öffnungen durch die Bodenplatte, die Deckelplatte und die Streben definiert wird, wobei zumindest ein Abschnitt einer Frontkante der Bodenplatte und ein Abschnitt einer Frontkante der Deckelplatte zusammen mit zwei Streben eine um eine Öffnung der Vielzahl von Öffnungen umlaufende Abdichtfläche für eine in die Öffnung einsetzbare Einsatzplatte bilden.
Da die Deckelplatte und die Bodenplatte eine genügend grosse Dicke aufweisen, können die Frontkanten dieser Platten selbst als abdichtendes Gegenstück zu den Einsatzplatten herangezogen werden können. Außerdem bringt die Nutzung der Frontkanten der Bodenplatte und der Deckelplatte als Dichtfläche den Vorteil mit sich, dass keine zusätzlichen Platten an die Rahmenkonstruktion angeschweißt werden müssen. Weiterhin führt die Einbeziehung der Frontkanten der Deckelplatte und der Bodenplatte als Dichtfläche dazu, dass die Flansch- bzw. Einsatzplatten bei ähnlicher Höhe der Vakuumkammer in der Höhe deutlich größer hergestellt werden können.
Darüber hinaus können Gewindebohrungen, welche beispielsweise dazu dienen, die Einsatzplatten über Schrauben darin zu befestigen, direkt in die Deckelplatte und die Bodenplatte gebohrt werden, was zu günstigen Fertigungskosten ohne jeglichen Präzisionsverlust führt.
Da als Stege des Rahmens einzelne Stangen verwendet werden, die zunächst getrennt von der Bodenplatte und der Deckelplatte sind und erst beim Zusammenbau mit diesen beispielsweise durch Schweißen dicht verbunden werden, ist bei der Herstellung des Rahmen kein Biegeschritt notwendig und die Stege können mit einer eine erhöhte Stabilität garantierenden Dicke hergestellt werden.

Erfindungsgemäß weisen die Bodenplatte und/oder die Deckelplatte jeweils eine Dicke von zumindest 3 cm auf. Dies führt zu einer hohen Stabilität gegenüber der aufgrund des Vakuums entstehenden Belastung der Vakuumkammer.

Erfindungsgemäß sind die Bodenplatte und/oder die Deckelplatte in Form einer vieleckigen Platte ausgebildet. Erfindungsgemäß ist dabei die Form eines Acht- oder Zehnecks.

Gemäß noch einer bevorzugten Ausführungsform bilden die Bodenplatte, die Deckelplatte und die Streben einen prismatischen Körper.

Erfindungsgemäß sind die Streben jeweils als Fünfkantprofile ausgebildet. Durch Vorsehen der fünfeckigen Querschnittform der Streben, welche beispielsweise durch Fräsen hergestellt werden kann, wird eine weitere Optimierung der Stabilität der Vakuumkammer gegenüber der beim Evakuieren der Vakuumkammer auftretenden Kräften erzielt. Außerdem benötigen die als Fünfkantprofile gearbeiteten Streben wenig Platz hinsichtlich des Umfangs der Vakuumkammer.

Erfindungsgemäß sind die Bodenplatte und/oder die Deckelplatte an jeweiligen Positionen, an welchen die Streben daran anbringbar sind, mit Zentrierlöchern versehen, was eine Montage des Rahmens erleichtert.
Es ist darüber hinaus bevorzugt, wenn die Bodenplatte und/oder die Deckelplatte an jeweiligen Positionen, an welchen die Streben anbringbar sind, eine Anschrägung für eine spätere Schweißnaht aufweisen.
Besonders bevorzugt ist auch, dass die Streben jeweils mit zumindest einer Gewindebohrung versehen sind. Dies ermöglicht es, die Einsatzplatten von außen an die Stege mittels Schrauben anzuschrauben, was eine gut dichtende Verbindung zwischen den Einsatzplatten und dem Rahmen ohne die Gefahr von möglichen Leckagen gewährleistet. Durch diese Konfiguration wird darüber hinaus auch ein Anordnen der Einsatzplatten auf Stoß nebeneinander ermöglicht, was zu einer Platzersparnis von beispielsweise 4 bis 5 cm gegenüber den aus dem Stand der Technik bekannten Systemen führt. Dies hat wiederum zur Folge, dass bei gleichem Durchmesser der Vakuumkammer mehr Einsatzplatten vorgesehen werden können.

Gemäß einer weiteren bevorzugten Ausführungsform sind die Einsatzplatten von außen an die Streben anbringbar, insbesondere mittels Schrauben anschraubbar, was eine dichte jedoch dennoch lösbare Verbindung herstellt. Zwischen den Rahmenteilen der Vakuumkammer und den Einsatzteilen können auch zusätzliche Dichtmittel, beispielsweise eine Gummidichtung, eingesetzt werden.

Es ist weiterhin bevorzugt, dass die Streben an ihren jeweiligen Enden angefast sind, was ein Anbringen der Schweißnaht deutlich vereinfacht.

Vorzugsweise sind die Einsatzplatten der Vakuumkammer aus Aluminium hergestellt. Dies führt zu geringeren Fertigungskosten.

Gemäß noch einer weiteren bevorzugten Ausführungsform weist die Vakuumkammer zum Öffnen und Schließen der Vakuumkammer eine Tür auf.

Erfindungsgemäss wird außerdem ein Verfahren zum Herstellen einer Vakuumkammer für Beschichtungsanlagen bereitgestellt, welches die folgenden Schritte umfasst: Zusammenstecken eines Rahmens, welcher eine Bodenplatte, eine Deckelplatte und Streben aufweist, welche die Bodenplatte und die Deckelplatte verbinden, und Verschweißen der Bodenplatte und der Deckelplatte mit den Streben. Durch das erfindungsgemässe Verfahren kann auf einfache Art und Weise eine Vakuumkammer mit hoher Stabilität und großer Flexibilität hinsichtlich Änderungen vorgesehen werden.
Um den Schritt des Verschweißens zu erleichtern, wird der bereits zusammengesteckte Rahmen beim Verschweißen in einer Stützkonstruktion gehalten. Hierdurch bleibt der Rahmen in einer definierten Form und der durch das Schweissen auftretende Verzug des Rahmens wird minimiert.
Vorzugsweise wird der Rahmen nach dem Verschweißen gefräst und anschließend gesandstrahlt.
Im Folgenden wird die Erfindung anhand eines Ausführungsbeispiels unter Bezugnahme auf die Zeichnung detailliert erläutert. In der Zeichnung zeigen:
- Fig. 1: eine Draufsicht auf eine Vakuumkammer gemäß einer Ausführungsform;
- Fig. 2: eine Seitenansicht der in Figur 1 dargestellten Vakuumkammer; und
- Fig.3: eine Detailansicht einer Verbindungsstelle einer Strebe mit einem Abschnitt der Deckelplatte.

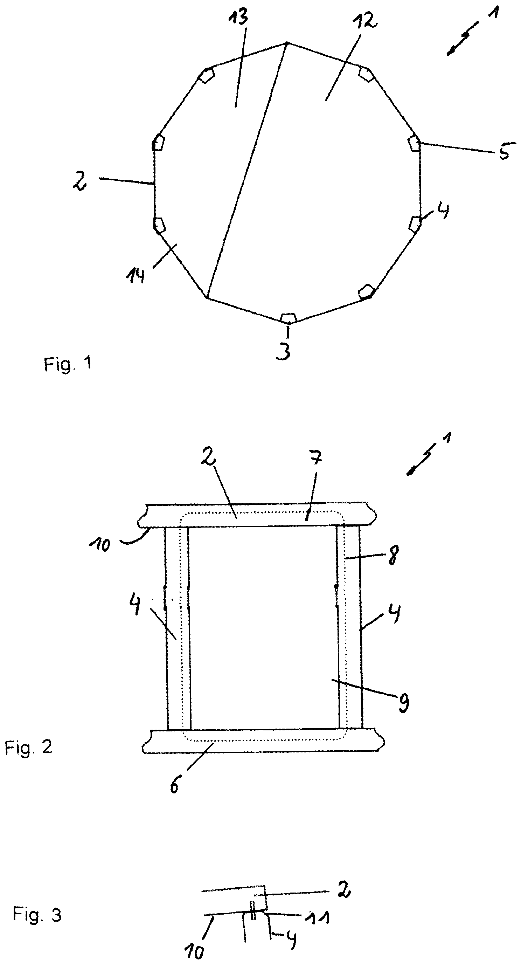

Figur 1 zeigt eine Draufsicht auf eine Vakuumkammer 1 bzw. auf die den oberen Abschluss der Vakuumkammer 1 bildende Deckelplatte 2. Es sei angemerkt, dass die Bodenplatte (hier nicht dargestellt) im Wesentlichen wie die Deckelplatte 2 ausgebildet ist, so dass die beiden Platten zusammen mit den Streben und den Einsatzplatten (hier ebenfalls nicht dargestellt) eine Vakuumkammer 1 in Form eines Prismas bilden. Die Deckelplatte 2 gemäß dieser Ausführungsform ist als Zehneck bzw. als zehneckige Platte geformt. An jeder Ecke 3 der Deckelplatte 2 ist eine Strebe 4 angeordnet, der die Deckelplatte 2 mit der Bodenplatte verbindet.

Die Position der Strebe 4 an der hier nicht sichtbaren Unterseite der Deckelplatte 2 bzw. deren äußere Umrisse sind in der Figur schematisch durch jeweilige Fünfecke 5 angedeutet. Die Deckelplatte 2 und auch die Bodenplatte können an den Stellen, an welchen die Streben 4 angeordnet werden, jeweils eine hier nicht dargestellte Bohrung für einen Zentrierstift sowie eine ebenfalls in der Figur nicht dargestellte Anschrägung für eine spätere Schweissnaht aufweisen.

Zur Herstellung der Deckplatte 2 und der Bodenplatte kann Wasserschneiden verwendet werden, wodurch die Platten in die gewünschte Form gebracht werden können.

Weiterhin ist in Figur 1 erkennbar, dass die Deckelplatte 2 in einen ersten Abschnitt 12 und einen zweiten Abschnitt 13 unterteilt ist, wobei der zweite Abschnitt 13 zu einer Tür 14 gehört, welche zum Öffnen und Schließen der Vakuumkammer 1 vorgesehen ist.

Figur 2 zeigt eine Seitenansicht der in Figur 1 dargestellten Vakuumkammer 1. Ein wesentliches Merkmal der erfindungsgemässen Vakuumkammer 1 ist, dass die Deckelplatte 2 und die Bodenplatte 6 jeweils dick genug sind, damit deren jeweilige Frontkanten 15, 15' zusammen mit jeweils zwei Streben 4 eine umlaufende Dichtfläche 7 für eine Einsatzplatte 8 (schematisch in der Figur durch die gestrichelte Linie dargestellt) zur Verfügung stellen können, welche in eine Öffnung 9 einsetzbar ist. Beispielsweise kann die Dicke der Deckelplatte 2 und der Bodenplatte 6 3 cm betragen. Dies führt zu einer hohen Stabilität gegenüber der aufgrund des Vakuums entstehenden Belastung. Die Nutzung der Frontkanten 15, 15' der Bodenplatte 6 und der Deckelplatte 2 als Dichtfläche 7 führt dazu, dass keine zusätzlichen Platten an die Konstruktion geschweisst werden müssen. Ausserdem können Gewindebohrungen (nicht dargestellt) direkt in die Deckelplatte 2 und die Bodenplatte 6 gebohrt werden, was zu günstigen Fertigungskosten bei dennoch hoher Genauigkeit führt.

Die Streben 4 sind aus massiven Metallstangen gefertigt, welche in der hier dargestellten Ausführungsform in die bereits oben diskutierte 5-Eckform gefräst sind. Damit sind sie optimiert hinsichtlich Stabilität gegenüber der beim Evakuieren der Vakuumkammer 1 auftretenden Kräften und benötigen wenig Platz hinsichtlich des Kammerumfangs.

Die Einsatzplatten 8 sind in der Ausführungsform von aussen an die Streben 4 angeschraubt.

Figur 3 zeigt schließlich eine Detailansicht einer Verbindungsstelle einer Strebe 4 mit einem Abschnitt der Deckelplatte 2. Wie in der Figur erkannt werden kann, ist die Strebe 4 an ihrem an die Unterseite 10 der Deckelplatte 2 angrenzenden Endabschnitt 11 stark angefast, was ein Anbringen einer Schweissnaht deutlich vereinfacht. Der hier nicht dargestellte, an die Bodenplatte 6 angrenzende Endabschnitt der Strebe 4 ist analog zum Endabschnitt 11 ausgebildet.

Zum Aufbau der Vakuumkammer wird der Rahmen bestehend aus der oben beschriebenen Deckelplatte 2, der Bodenplatte 6 und den Streben 4 zusammengesteckt und ein Türflansch angebracht. Dabei ist es vorteilhaft, wenn der Rahmen durch eine Stützkonstruktion gehalten wird.

Anschliessend werden die Deckelplatte 2 und die Bodenplatte 6 mit den Streben 4 verschweisst. Dabei haben die Platten und die Streben Übermass, damit später auf Mass gefräst werden kann. Unebenheiten beim Schweissen können dadurch leicht durch Fräsen beseitigt werden.

Sollte aufgrund einer hohen Prozesstemperatur eine Kühlung notwendig sein, so beschränkt sich diese auf die Deckplatte 2 und die Bodenplatte 6 bzw. -flansche, da die Seitenteile bzw. Einsatzplatten 8 vollständig aus Aluminium bestehen.

Nach dem Verschweissen wird die Stützkonstruktion kurzzeitig gelockert. Dies erlaubt eine Entspannung des Systems. Um gegebenenfalls anschliessende Fräsarbeiten durchführen zu können, wird die Stützkonstruktion wieder befestigt. Abschliessend wird der so entstandene Rahmen noch beispielsweise mittels Sandstrahlen gereinigt. In analoger Weise kann beispielsweise die Tür 14 hergestellt werden

Es sei angemerkt, dass der mittels des erfindungsgemässen Verfahrens hergestellte Rahmen im Vergleich zu aus dem Stand der Technik bekannten Rahmen eine höhere Stabilität besitzt, wobei jedoch die Vakuumkammer ihre endgültige Stabilität durch die an dem Rahmen angebrachten aus Aluminium hergestellten Einsatzplatten 8 erhält.

### Bezugszeichenliste

- 1: Vakuumkammer
- 2: Deckelplatte
- 3: Ecke
- 4: Steg
- 5: Fünfeck
- 6: Bodenplatte
- 7: Dichtfläche
- 8: Einsatzplatte
- 9: Öffnung
- 10: Unterseite der Deckelplatte
- 11: Endabschnitt der Strebe
- 12: erster Abschnitt
- 13: zweiter Abschnitt
- 14: Tür
- 15, 15': Frontkante

## Patentansprüche

1. Vakuumkammer (1) für Beschichtungsanlagen, wobei die Vakuumkammer (1) eine Bodenplatte (6) und eine Deckelplatte (2) aufweist, welche durch im Wesentlichen senkrecht zu der Bodenplatte (6) und der Deckelplatte (2) verlaufende Streben (4) miteinander verbunden sind, wobei eine Vielzahl von Öffnungen (9) durch die Bodenplatte (6), die Deckelplatte (2) und die Streben (4) definiert wird, wobei zumindest ein Abschnitt einer Frontkante (15') der Bodenplatte (6) und ein Abschnitt einer Frontkante (15) der Deckelplatte (2) zusammen mit zwei Streben (4) eine um eine Öffnung (9) der Vielzahl von Öffnungen (9) umlaufende Dichtflache (7) für eine in die Öffnung (9) einsetzbare Einsatzplatte (8) bilden, wobei die Deckelplatte (2) und die Bodenplatte (6) dergestalt ausgelegt sind, dass die Frontkanten (15, 15') dieser Platten (2, 6) selbst als abdichtendes Gegenstück zu dem Einsatzplatte (8) wirken,
**dadurch gekennzeichnet, dass** die Vakuumkammer eine erhöhte Stabilität aufweist indem:
a) die Bodenplatte (6) und die Deckelplatte (2) jeweils eine Dicke von zumindest 3 cm aufweisen, wobei die Bodenplatte (6) und/oder die Deckelplatte (2) an jeweiligen Positionen, an welchen die Streben (4) anbringbar sind, mit Zentrierlöchern versehen sind, und
b) die Streben (4) jeweils als Fünfkantprofile ausgebildet sind, welche aus massiven Metallstangen gefertigt und in die 5-Eckform gefräst sind, wobei die Streben (4) mit der Bodenplatte (6) und der Deckelplatte (2) durch Schweissen dicht verbunden sind, und
c) die Bodenplatte und/oder Deckelplatte in Form einer vieleckigen Platte eines Acht- oder Zehnecks ausgebildet sind.

2. Vakuumkammer (1) gemäss dem Anspruch 1, **dadurch gekennzeichnet, dass** die Deckelplatte (2) und die Bodenplatte (6) Gewindebohrungen aufweisen.

3. Vakuumkammer (1) gemäss einem der vorangehenden Ansprüche 1 bis 2, **dadurch gekennzeichnet, dass** die Bodenplatte (6), die Deckelplatte (2) und die Streben (4) einen prismatischen Körper bilden.

4. Vakuumkammer (1) gemäss einem der vorangehenden Ansprüche 1 bis 3, **dadurch gekennzeichnet, dass** die Deckelplatte (2) in einen ersten Abschnitt (12) und in einen zweiten Abschnitt (13) unterteilt ist, wobei der zweite Abschnitt (13) zu einer Tür (14) gehört, welche zum Öffnen und Schliessen der Vakuumkammer (1) vorgesehen ist.

5. Vakuumkammer (1) gemäss einem der vorangehenden Ansprüche 1 bis 4, **dadurch gekennzeichnet, dass** die Bodenplatte (6) und/oder die Deckelplatte (2) an jeweiligen Positionen, an welchen die Streben (4) anbringbar sind, eine Anschrägung aufweisen.

6. Vakuumkammer (1) gemäss einem der vorangehenden Ansprüche 1 bis 5, **dadurch gekennzeichnet, dass** die Streben (4) jeweilig mit zumindest einer Gewindebohrung versehen sind.

7. Vakuumkammer (1) gemäss einem der vorangehenden Ansprüche 1 bis 6, **dadurch gekennzeichnet, dass** die Einsatzplatten (8) von aussen an die Streben (4) anbringbar, insbesondere mittels Schrauben anschraubbar, sind.

8. Vakuumkammer (1) gemäss einem der vorangehenden Ansprüche 1 bis 7, **dadurch gekennzeichnet, dass** die Streben (4) an ihren jeweiligen Endabschnitten (11) angefast sind.

9. Vakuumkammer (1) gemäss einem der vorangehenden Ansprüche 1 bis 8, **dadurch gekennzeichnet, dass** die Einsatzplatten (8) aus Aluminium hergestellt sind.

10. Verfahren zum Herstellen einer Vakuumkammer (1) für Beschichtungsanlagen nach einem der vorangehenden Ansprüche 1 bis 9, **dadurch gekennzeichnet, dass** das Verfahren die folgenden Schritte umfasst:
- Zusammenstecken eines Rahmens, welcher eine Bodenplatte (6), eine Deckelplatte (2) und Streben (4) aufweist, welche die Bodenplatte (6) und die Deckelplatte (2) verbinden, und
- Verschweissen der Bodenplatte (6) und der Deckelplatte (2) mit den Streben (4),
- Anbringen von Einsatzplatten (8) an den Rahmen
wobei der bereits zusammengesteckte Rahmen beim Verschweissen in einer Stützkonstruktion gehalten wird, um den Schritt des Verschweissens zu erleichtern, wobei auf diese Weise der Rahmen in einer definierten Form bleibt und somit der durch das Schweissen auftretende Verzug des Rahmens minimiert wird.

11. Verfahren gemäss dem Anspruch 10, **dadurch gekennzeichnet, dass** die Deckelplatte (2) und die Bodenplatte (6) an den Stellen, an welchen die Streben 4 angeordnet werden, jeweils für das Zusammenstecken eine Bohrung für einen Zentrierstift und für eine Schweissnaht eine Anschrägung aufweisen.

12. Verfahren gemäss einem der vorangehenden Ansprüche 10 bis 11, **dadurch gekennzeichnet, dass** zur Herstellung der Deckplatte (2) und der Bodenplatte (6) Wasserschneiden verwendet werden, wodurch die Platten in die gewünschte Form gebracht werden können.

13. Verfahren gemäss einem der vorangehenden Ansprüche 10 bis 12, **dadurch gekennzeichnet, dass** die Streben (4) jeweils an ihrem an die Unterseite (10) der Deckplatte (2) und an die Bodenplatte (6) angrenzenden Endabschnitt (11) angefast sind, um ein Anbringen einer Schweissnaht zu vereinfachen.

14. Verfahren nach einem der vorangehenden Ansprüche 10 bis 13, **dadurch gekennzeichnet, dass** der Rahmen nach dem Verschweissen gefräst und anschliessend gesandstrahlt wird.

## Claims

1. Vacuum chamber (1) for coating installations, wherein the vacuum chamber (1) has a bottom plate (6) and a top plate (2), which are connected to each other by struts (4) running essentially perpendicularly to the bottom plate (6) and the top plate (2), wherein a plurality of openings (9) are defined by the bottom plate (6), the top plate (2) and the struts (4), wherein
at least a portion of a front edge (15') of the bottom plate (6) and a portion of the front edge (15) of the top plate (2) form together with two struts (4) a sealing area, running around one opening (9) of the multiplicity of openings (9), for an insert plate (8) that can be inserted into the opening (9), wherein the top plate (2) and the bottom plate (6) are designed such that the front edges (15, 15') of these plates (2, 6) act as sealing counterpart to the insert plate (8), **characterized in that** the vacuum chamber has an increased stability wherein:
a) the bottom plate (6) and the top plate (2) each having a thickness of at least 3 cm,
wherein the bottom plate (6) and/or the top plate (2) are provided with centering holes at the respective positions where the struts (4) can be fastened thereto and
b) the struts (4) are each made in a pentagonal profile
which are made of massive metal rods and milled in the pentagonal shape, wherein the struts (4) are connected tightly to the bottom plate (6) and the top plate (2) by welding, and
c) the bottom plate and/or the top plate are made in the form of a multi-angular plate of an octagon or decagon.

2. Vacuum chamber (1) according to claim 1, **characterized in that** the top plate (2) and the bottom plate (6) have threaded holes.

3. Vacuum chamber (1) according to one of the preceding claims 1 to 2, **characterized in that** the bottom plate (6), the top plate (2) and the struts (4) form a prismatic body.

4. Vacuum chamber (1) according to one of the preceding claims 1 to 3 **characterized in that** the top plate (2) is divided into a first portion (12) and a second portion (13), wherein the second portion (13) is part of a door (14) that is provided for opening and closing the vacuum chamber (1).

5. Vacuum chamber (1) according to one of the preceding claims 1 to 4, **characterized in that** the bottom plate (6) and/or the top plate (2) are provided with a tapered edge at the respective positions where the struts (4) can be fastened thereto.

6. Vacuum chamber (1) according to one of the preceding claims 1 to 5, **characterized in that** the struts (4) are each provided with at least one threaded hole.

7. Vacuum chamber (1) according to one of the preceding claims 1 to 6, **characterized in that** the insert plates (8) can be fastened to the struts (4) from the outside and can in particular be screwed thereto by means of screws.

8. Vacuum chamber (1) according to one of the preceding claims 1 to 7, **characterized in that** the struts (4) are chamfered at their respective ends (11).

9. Vacuum chamber (1) according to one of the preceding claims 1 to 8, **characterized in that** the insert plates (8) are made of aluminum.

10. Method for producing a vacuum chamber (1) for coating installations according to one of the preceding claims 1 to 9, **characterized in that** the method comprises the following steps:
- putting together a frame which has a bottom plate (6), a top plate (2) and struts (4), which connect the bottom plate (6) and the top plate (2), and
- welding the bottom plate (6) and the top plate (2) to the struts (4),
- fastening the insert plates (8) to the frame
wherein the already assembled frame is held during welding in a supporting structure in order to simplify the welding, wherein in this way the frame remains in a defined shape and warpage of the frame arising because of the welding is minimized.

11. Method according to claim 10 **characterized in that** the cover plate (2) and the bottom plate (6) can each have at the places where the struts (4) are placed, for putting together, a borehole for a centering pin as well as a tapered edge for a welding seam.

12. Method according to one of the preceding claims 10 to 11, **characterized in that** for the manufacturing of the top plate (2) and the bottom plate (6) water jet cutting is used through which the plates can be made in the desired shape.

13. Method according to one of the preceding claims 10 to 12 **characterized in that** the struts (4) are each chamfered at their end portion (11) adjacent to the underside (10) of the top plate (2) and to the bottom plate (6), which considerably simplifies the application of a welding seam.

14. Method according to one of the preceding claims 10 to 13, **characterized in that** after welding, the frame is milled and subsequently sandblasted.

## Revendications

1. Chambre à vide (1) pour des installations de revêtement, la chambre à vide (1) ayant une plaque de fond (6) et une plaque de recouvrement (2) qui sont reliées l'une à l'autre par des entretoises (4) s'étendant essentiellement perpendiculairement à la plaque de fond (6) et à la plaque de recouvrement (2), une pluralité d'orifices (9) étant définie par la plaque de fond (6), la plaque de recouvrement (2) et les entretoises (4), du moins une partie d'un bord frontal (15') de la plaque de fond (6) et une partie d'un bord frontal (15) de la plaque de recouvrement (2) formant avec deux entretoises (4) une surface d'étanchéité (7) circulant autour d'un orifice (9) de la pluralité des orifices (9) pour une plaque d'insertion (8) qui peut être insérée dans l'orifice (9), la plaque de recouvrement (2) et la plaque de fond (6) étant désignées de manière que les bords frontaux (15, 15') de ces plaques agissent comme contrepartie d'étanchéité à la plaque d'insertion (8),
**caractérisé en ce que** la chambre à vide a une stabilité accrue par le fait que
a) la plaque de fond (6) et la plaque de recouvrement (2) ont chacune une épaisseur d'au moins 3 cm,
la plaque de fond (6) et/ou la plaque de recouvrement (2) étant pourvues de trous de centrage aux positions respectives où les entretoises (4) peuvent être fixées et
b) les entretoises (4) sont des profils ayant chacune la forme d'un pentagone qui sont produits de massives barres métalliques et fraisées en forme pentagonale, les entretoises (4) étant reliées de façon étanche à la plaque de fond (6) et la plaque de recouvrement (2) par soudage, et
c) la plaque de fond et/ou la plaque de recouvrement ont la forme d'une plaque polygonale d'un octogone ou d'un décagone.

2. Chambre à vide (1) selon la revendication 1 **caractérisée en ce que** la plaque de recouvrement (2) et la plaque de fond (6) ont des alésages taraudés.

3. Chambre à vide (1) selon l'une des revendications précédentes 1 à 2 **caractérisée en ce que** la plaque de fond (6), la plaque de recouvrement (2) et les entretoises (4) ont un corps prismatique.

4. Chambre à vide (1) selon l'une des revendications précédentes 1 à 3 **caractérisée en ce que** la plaque de recouvrement (2) est divisée en une première partie (12) et en une deuxième partie (13), la deuxième partie (13) appartenant à une porte (14) prévue pour ouvrir et fermer la chambre à vide (1).

5. Chambre à vide (1) selon l'une des revendications précédentes 1 à 4 **caractérisée en ce que** la plaque de fond (6) et/ou la plaque de recouvrement (2) sont biseautées aux positions où les entretoises (4) peuvent être fixées.

6. Chambre à vide (1) selon l'une des revendications précédentes 1 à 5 **caractérisée en ce que** chacune des entretoises (4) est pourvue d'au moins un alésage taraudé.

7. Chambre à vide (1) selon l'une des revendications précédentes 1 à 6 **caractérisée en ce que** les plaques d'insertion (8) peuvent être fixées de l'extérieur aux entretoises (4), elles peuvent particulièrement être vissées au moyen de vis.

8. Chambre à vide (1) selon l'une des revendications précédentes 1 à 7 **caractérisée en ce que** les entretoises (4) sont chanfreinées à leurs extrémités (11) respectives.

9. Chambre à vide (1) selon l'une des revendications précédentes 1 à 8 **caractérisée en ce que** les plaques d'insertion (8) sont fabriquées en aluminium.

10. Procédure de fabrication d'une chambre à vide (1) pour des installations de revêtement selon l'une des revendications précédentes 1 à 9, **caractérisée en ce que** la procédure comprend les étapes suivantes:
- assembler un cadre ayant une plaque de fond (6), une plaque de recouvrement (2) et des entretoises (4) qui relient la plaque de fond (6) à la plaque de recouvrement (2) et
- souder la plaque de fond (6) et la plaque de recouvrement (2) avec les entretoises (4)
- fixer des plaques d'insertion (8) au cadre,
le cadre déjà assemblé étant tenu pendant le soudage dans une structure de support pour faciliter l'étape de soudage, permettant ainsi au cadre de rester dans une forme définie de sorte que la déformation du cadre causé par le soudage est minimisée.

11. Procédure selon la revendication 10 **caractérisée en ce que** la plaque de recouvrement (2) et la plaque de fond (6) ont chacune aux positions où les entretoises (4) sont placées, pour l'assemblage, un alésage pour une goupille de centrage et un biseautage pour un cordon de soudure.

12. Procédure selon l'une des revendication précédentes 10 à 11 **caractérisée en ce que** pour la fabrication de la plaque de recouvrement (2) et la plaque de fond (6) la découpe par jet d'eau est utilisée permettant aux plaques d'atteindre la forme désirée.

13. Procédure selon l'une des revendication précédentes 10 à 12 **caractérisée en ce que** chacune des entretoises (4) est chanfreinée à son extrémité (11) adjacent à la surface inférieure (10) de la plaque de recouvrement (2) et à la plaque de fond (6) pour faciliter la fixation d'un cordon de soudure.

14. Procédure selon l'une des revendication précédentes 10 à 13 **caractérisée en ce que** le cadre est biseauté après le soudage et ensuite sablé.
